# DEMANDE DE BREVET EUROPEEN

(11) **EP 0 828 325 A1**
(43) Date de publication de la demande: **11.03.1998**
(21) Numéro de dépôt: 97401980.4
(22) Date de dépôt: 25.08.1997
(51) Int. Cl.: H01S 3/25, H01S 3/085

(54) **Amplificateur optique à semi-conducteur**

(30) Priorité: 06.09.1996 FR 9610898
(71) Demandeur: ALCATEL ALSTHOM COMPAGNIE GENERALE D'ELECTRICITE, 75008 Paris (FR)
(72) Inventeur: Ducellier, Thomas, 91440 Bures Sur Yvette (FR)
(74) Mandataire: Fournier, Michel Robert Marie

(57) **Abrégé**

Selon cette invention un amplificateur optique à semi-conducteur du type III-V comporte sous forme intégrée un segment d'atténuation (A) en série entre un premier et un deuxième segments d'amplification (G1, G2).

Cette invention permet notamment de réaliser un convertisseur de longueur d'onde à vitesse élevée pouvant être utilisé avec avantage dans un système de télécommunication optique.

## Description

La présente invention concerne un amplificateur optique à semi-conducteur.

Elle trouve plus particulièrement application lorsqu'on dispose d'un signal porté par une onde optique sous la forme d'une modulation d'amplitude et lorsqu'on souhaite faire porter ce signal par une autre onde optique, ce qui constitue une transcription de ce signal. On utilise alors un dispositif de transcription et on injecte simultanément deux ondes dans ce dispositif. Une première onde est modulée par le signal à transcrire. Le dispositif inscrit ce signal sur la deuxième onde.

Un tel dispositif peut être notamment utilisé pour réaliser une conversion de longueur d'onde : dans un réseau de communication à multiplexage en fréquence un signal est reçu par un noeud du réseau dans un premier canal spectral et il est transmis au noeud suivant dans un deuxième canal spectral pouvant être différent du premier. La deuxième onde est alors dépourvue de toute modulation à l'entrée du dispositif.

Un tel dispositif peut aussi être utilisé notamment pour réaliser un démultiplexage temporel ou une récupération d'horloge tout optique.

Pour de telles applications les vitesses de travail souhaitées sont très élevées. Elles correspondent typiquement à une bande passante de l'ordre de 10 GHz.

Il est connu et économiquement avantageux de réaliser un tel dispositif de transcription à l'aide d'un amplificateur à semi-conducteur du type III-V fonctionnant au voisinage de la saturation. La modulation d'amplitude de la première onde provoque une modulation de la densité de porteurs de charges dans cet amplificateur. Cette modulation de densité entraîne une modulation correspondante du gain présenté par cet amplificateur pour la deuxième onde lumineuse. Elle applique ainsi à cette deuxième onde une modulation d'amplitude complémentaire de celle de la première onde, ce qui réalise la transcription souhaitée.

Dans le cas des applications mentionnées ci-dessus, il est apparu que la vitesse de travail des dispositifs connus n'était pas aussi grande que souhaitable et qu'elle était limitée, non seulement par le temps de vie des porteurs de charges dans le milieu amplificateur, mais aussi en raison du régime de travail de ce milieu, qui est proche de la saturation. Ce régime se traduit par une inhomogénéité de la distribution des porteurs de charges sur la longueur du guide amplificateur, cette inhomogénéité étant liée à celle de la distribution longitudinale de puissance optique. Pour s'affranchir de cette limitation intrinsèque de la vitesse liée aux porteurs, deux solutions ont été envisagées :

Une première solution connue consiste à ne plus utiliser la modulation de gain induite par la déplétion des porteurs, mais plutôt une modulation de phase dans un dispositif interférométrique (du type MZ-SOA). Cette solution requiert de réaliser un interféromètre intégré comprenant au moins deux amplificateurs à semi-conducteurs. Elle est technologiquement complexe. Elle n'améliore pas intrinsèquement le composant, mais fait intervenir un autre effet physique plus rapide. Elle a été décrite dans une communication : Penalty free All-optical wavelength conversion by SOAs in Mach-Zehnder Configuration, T. Durhuus & al. Ecoc'93 paper Tu C 5.2 pp129-132.

Une deuxième solution connue consiste à pomper optiquement très fortement le milieu amplificateur pour que la densité d'équilibre des porteurs soit atteinte plus rapidement. Cette méthode est efficace, mais elle nécessite l'intervention coûteuse d'un troisième faisceau (dit "holding beam") de forte puissance. Elle a été décrite dans un article :
Enhanced recovery rates in semiconductor laser amplifiers using optical pumping, Manning & al. Elec. Lett. vol 30 n° 10 pp 787 -788, 1994.

La présente invention a notamment pour but de réaliser un amplificateur optique qui permette une vitesse de travail accrue dans le cas où il est utilisé comme dispositif de transcription de signal.

Elle a plus généralement pour but de réaliser un amplificateur optique à semi-conducteur tel que la répartition longitudinale de la densité des porteurs de charges et/ou la répartition longitudinale de la densité de puissance optique dans le guide optique amplificateur soient mieux adaptées que précédemment à une utilisation de cet amplificateur, notamment lorsque le milieu constituant ce guide doit fonctionner au voisinage de la saturation.

Elle a en même temps pour but de réaliser un tel amplificateur d'une manière simple et peu coûteuse et sous une forme intégrée.

Dans ces buts un amplificateur optique à semi- conducteur comporte sous forme intégrée un segment d'atténuation à réponse linéaire inséré en série entre un premier et un deuxième segments d'amplification.

Selon cette invention on peut adopter en outre avec avantage, selon l'utilisation de cet amplificateur, l'une et/ou l'autre des deux dispositions suivantes :
- L'atténuation du segment d'atténuation est inférieure au gain du premier segment d'amplification tout en étant suffisante pour éviter une saturation du gain du deuxième segment d'amplification.
- L'atténuation du segment d'atténuation est comprise entre 0,5 ou 1 dB et 20 dB.

A l'aide des deux figures schématiques ci-jointes on va décrire plus particulièrement ci-après, à titre d'exemple, un mode de mise en oeuvre de cette invention.

La figure 1 représente une vue de dessus de la structure guidante d'un amplificateur selon cette invention.

La figure 2 représente une vue de l'amplificateur de la figure 1 en coupe selon un plan vertical longitudinal II-II de la figure 1.

Conformément à ces figures l'amplificateur donné en exemple comporte une plaquette semi-conductrice monocristalline 2. Cette plaquette présente un indice de réfraction de masse. Elle comporte elle même de bas en haut, les couches ou ensembles de couches superposées suivantes:
- Une couche de confinement inférieure 4 d'un premier type de conductivité qui est par exemple le type n.
- Une structure guidante 6 incluant une succession de segments longitudinaux présentant un indice de réfraction diminué, c'est à dire plus petit que ledit indice de masse, pour constituer des segments guidants formant un trajet pour des ondes lumineuses WA, WB. Il s'agit typiquement de deux ondes lumineuses ayant deux longueurs d'onde situées dans le domaine allant de 1510 à 1580 nm. Le trajet des ondes lumineuses inclut les segments d'atténuation A et d'amplification G1 et G2).
- Enfin une couche de confinement supérieure 8 d'un deuxième type de conductivité opposé au premier, par exemple du type p.

Des électrodes El, E2 et M sont formées sur les faces inférieure 10 et supérieure 12 de la plaquette 2 pour faire passer à travers cette plaquette des courants d'alimentation injectant lesdits porteurs de charges dans les segments d'amplification à partir de couches des premier et deuxième types de conductivité. Ces courants sont fournis par une source de courant Q avec des intensités propres à réaliser lesdits gains des premier et deuxième segments d'amplification G1 et G2.

Plus particulièrement, la structure guidante 6 comporte :
- une couche guidante inférieure 14,
- une couche de confinement intermédiaire 16 dudit premier type de conductivité, et
- une couche guidante supérieure 18.

L'épaisseur de la couche de confinement intermédiaire est suffisamment petite pour permettre un couplage optique par ondes évanescentes entre les couches guidantes inférieure et supérieure. La couche guidante inférieure comporte en succession longitudinale :
- un premier segment de raccordement R1 guidant,
- un premier intervalle non guidant H1,
- ledit segment d'atténuation A,
- un deuxième intervalle non guidant H2, et
- un deuxième segment de raccordement guidant R2.
La couche guidante supérieure comporte en succession longitudinale :
- un premier intervalle non guidant K1 superposé au premier segment de raccordement R1,
- ledit premier segment d'amplification G1 superposé au premier intervalle non guidant H1 de la couche guidante inférieure,
- un deuxième intervalle non guidant K2 superposé au segment d'atténuation A,
- ledit deuxième segment d'amplification G2 superposé au deuxième intervalle non guidant H2 de la couche guidante inférieure, et
- un troisième intervalle non guidant K3 superposé au deuxième segment de raccordement.

Ledit trajet des ondes lumineuses est ainsi réalisé à l'aide de couplages par ondes évanescentes entre les couches guidantes inférieure 14 et supérieure 18. Il comporte une succession de segments guidants constitués par le premier segment de raccordement R1, le premier segment d'amplification G1, le segment d'atténuation A, le deuxième segment d'amplification G2 et le deuxième segment de raccordement R2.

Les segments d'amplification présentent une largeur adaptée à leur fonction. Cette largeur est plus petite que celle des segments de raccordement qui doivent permettre de réaliser un couplage à faibles pertes à un composant extérieur, tel qu'une fibre optique. De manière connue, une structure de transition telle que T est prévue pour chacun desdits couplages associant deux segments guidants successifs. Ces deux segments guidants sont un segment amont tel que R1 appartenant à l'une des deux couches guidantes telle que 14 et un segment aval tel que G1 appartenant à l'autre telle que 18 des deux couches guidantes. Cette structure de transition occupe un segment de transition commun aux deux dits segments guidants. Elle y est réalisée par une décroissance longitudinale progressive de la largeur du segment amont s'accompagnant d'une croissance longitudinale progressive de la largeur du segment aval.

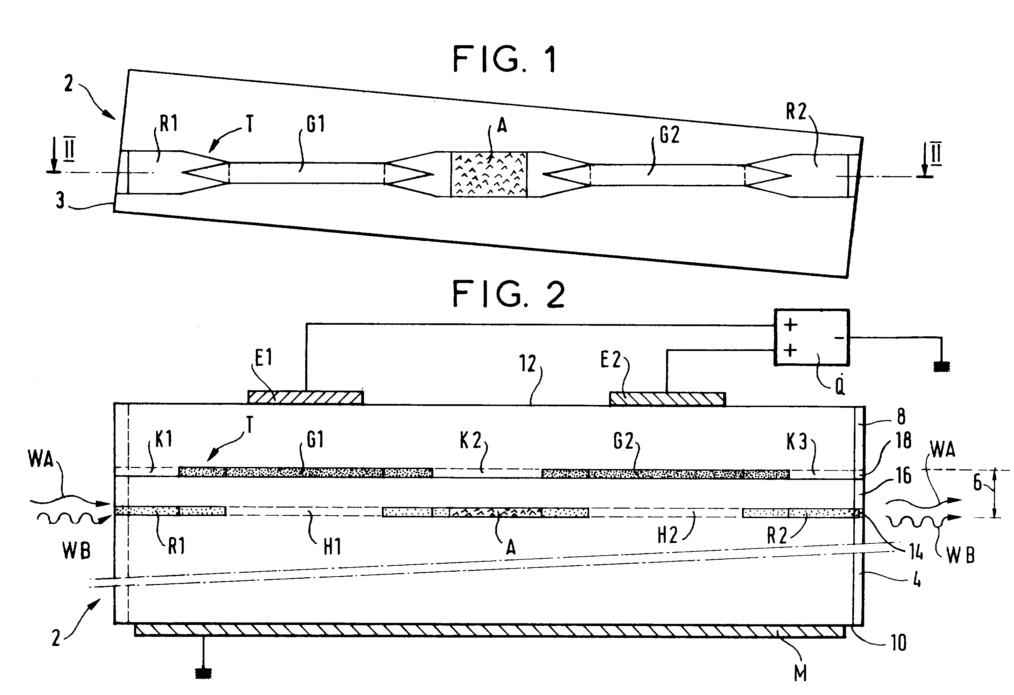

Sur la figure 2 les zones à indice de réfraction diminué sont représentées avec des pointillés. Conformément à la figure 1 les deux faces extrêmes telles que 3 de la plaquette 2 sont inclinées par rapport à la direction longitudinale qui est celle des segments guidants. Cette inclinaison évite de manière connue une oscillation optique parasite de l'amplificateur.

Divers moyens bien connus permettent d'obtenir l'atténuation souhaitée dans chaque segment d'atténuation. Un tel moyen est par exemple une implantation de protons qui induit des dislocations dans le réseau cristallin. Ces dislocations sont symbolisées sur la figure 1 par des V renversés.

La plaquette 2 est par exemple constituée à base de phosphure d'indium. Des alliages ternaires ou quaternaires sont utilisés de manière connue pour constituer les segments guidants.

Quoique le mode de réalisation indiqué ci-dessus apparaisse avantageux il doit être compris que les segments d'amplification et d'atténuation pourraient être réalisés au sein d'une même couche guidante, et que l'amplificateur pourrait comporter deux segments d'atténuation, ou davantage, et trois segments d'amplification ou davantage.

Il convient dans tous les cas que chaque segment d'atténuation compense partiellement le gain du segment d'amplification précédent, ce gain constituant par exemple un premier gain, pour permettre au segment d'amplification suivant de procurer lui aussi un gain de puissance aux ondes lumineuses guidées, ce gain constituant par exemple un deuxième gain. Ce deuxième gain permet une deuxième transcription d'un signal d'une première onde à une deuxième onde en complément à une première telle transcription précédemment réalisée dans le premier segment d'amplification. Il a été trouvé que cette deuxième transcription élève la borne supérieure de la bande passante de la transcription. Ceci peut résulter du fait que les transcriptions du signal de la première onde sur la deuxième onde correspondent à un filtrage passe bas. Le premier segment d'amplification correspond quant à lui à un filtrage passe haut pour le signal porté par la première onde. Lors de la deuxième transcription une compensation partielle apparaît alors entre, d'une part le rôle de filtre passe bas joué par cette deuxième transcription vis à vis du signal porté par la deuxième onde, et d'autre part le rôle de filtre passe haut qui a été joué par le premier segment d'amplification vis à vis du signal porté par la première onde.

Conformément à la présente invention il a aussi été trouvé que, au moins dans le cas des amplificateurs à semi-conducteurs connus, qui sont constitués de matériaux du type III-V, la première transcription n'était convenablement réalisée qu'à la condition que le premier gain présente une valeur suffisante, et que cette valeur suffisante du premier gain était telle que, si elle était réalisée en l'absence d'atténuation, la puissance des ondes lumineuses en entrée du deuxième segment d'amplification saturerait ce segment. Le gain de ce deuxième segment serait supprimé. En ce qui concerne la bande passante de la transcription globale, ceci ferait perdre le bénéfice de la deuxième transcription.

De manière générale la présente invention permet le choix de l'atténuation de chaque segment d'atténuation et celui du courant d'alimentation de chaque segment d'amplification ou d'autres paramètres de ces segments, notamment de ses dimensions et de sa composition. Elle permet ainsi de réaliser dans chaque segment d'amplification la densité de porteurs de charges et la densité de puissance optique la plus convenable pour une utilisation souhaitée d'un amplificateur.

Par ailleurs la courbe spectrale de gain du deuxième segment d'amplification peut avantageusement présenter un décalage spectral par rapport à la courbe spectrale du gain du premier segment d'amplification. Un tel décalage est typiquement compris entre 5 nm et 50 nm. Il vaut par exemple 30 nm. Il permet d'aplatir la courbe spectrale de gain global de l'amplificateur.

## Revendications

1. Amplificateur optique à semi-conducteur, caractérisé en ce qu'il comporte sous forme intégrée un segment d'atténuation (A) à réponse linéaire, inséré en série entre un premier et un deuxième segments d'amplification (G1, G2).

2. Amplificateur selon la revendication 1, l'atténuation dudit segment d'atténuation (A) étant inférieure au gain dudit premier segment d'amplification (G1) tout en étant suffisante pour éviter une saturation du gain dudit deuxième segment d'amplification (G2).

3. Amplificateur selon la revendication 1, l'atténuation dudit segment d'atténuation (A) étant comprise entre 0,5 dB et 20 dB.

4. Amplificateur selon la revendication 3, ladite atténuation étant supérieure à 1 dB.

5. Amplificateur selon la revendication 2, cet amplificateur comportant une plaquette semi-conductrice monocristalline (2) présentant un indice de réfraction de masse et comportant elle même :
- une face inférieure (10),
- une couche de confinement inférieure (4) d'un premier type de conductivité (n),
- une structure guidante (6) incluant une succession de segments longitudinaux présentant un indice de réfraction diminué pour constituer des segments guidants formant un trajet pour des ondes lumineuses (WA, WB), ce trajet des ondes lumineuses incluant les dits segments d'atténuation (A) et d'amplification (G1,G2) en série, ces segments d'amplification étant propres à réaliser une amplification de ces ondes lumineuses par recombinaison de porteurs de charges, cette amplification étant réalisée avec des gains locaux proportionnés à des densités locales de ces porteurs,
- une couche de confinement supérieure (8) d'un deuxième type de conductivité (p) opposé au premier, et
- une face supérieure (12),
cet amplificateur comportant en outre :
- des électrodes (E1,E2,M) formées sur lesdites faces inférieure (10) et supérieure (12) de ladite plaquette (2) pour faire passer à travers cette plaquette des courants d'alimentation injectant lesdits porteurs de charges dans lesdits segments d'amplification à partir de couches des dits premier et deuxième types de conductivité,
- et une source de courant (Q) pour fournir lesdits courants d'alimentation avec des intensités propres à réaliser lesdits gains desdits premier et deuxième segments d'amplification (G1,G2).

6. Amplificateur selon la revendication 5, ladite structure guidante (6) comportant :
- une couche guidante inférieure (14),
- une couche de confinement intermédiaire (16) du dit premier type de conductivité (n), et
- une couche guidante supérieure (18),
l'épaisseur de la couche de confinement intermédiaire étant suffisamment petite pour permettre un couplage optique entre les couches guidantes inférieure et supérieure, ladite couche guidante inférieure comportant en succession longitudinale :
- un premier segment de raccordement (R1) guidant,
- un premier intervalle non guidant (H1),
- ledit segment d'atténuation (A),
- un deuxième intervalle non guidant (H2), et
- un deuxième segment de raccordement guidant (R2),
ladite couche guidante supérieure comportant en succession longitudinale :
- un premier intervalle non guidant (K1) superposé au premier segment de raccordement (R1),
- ledit premier segment d'amplification (G1) superposé au premier intervalle non guidant (H1) de la couche guidante inférieure,
- un deuxième intervalle non guidant (K2) superposé au segment d'atténuation (A),
- ledit deuxième segment d'amplification (G2) superposé au deuxième intervalle non guidant (H2) de la couche guidante inférieure, et
- un troisième intervalle non guidant (K3) superposé au deuxième segment de raccordement, de manière que ledit trajet des ondes lumineuses soit réalisé à l'aide de couplages entre les couches guidantes inférieure (14) et supérieure (18) et comporte une succession de dits segments guidants constitués par le premier segment de raccordement (R1), le premier segment d'amplification (G1), le segment d'atténuation (A), le deuxième segment d'amplification (G2) et le deuxième segment de raccordement (R2),
- lesdits segments d'amplification présentant une largeur plus petite que lesdits segments de raccordement et d'atténuation,
- une transition (T) étant prévue pour chaque couplage entre un segment amont (R1) constitué par l'un desdits segments guidants et appartenant à l'une des deux dites couches guidantes (14) et un segment aval (G1) constitué par le suivant desdits segments guidants et appartenant à l'autre (18) des deux dites couches guidantes, cette transition étant réalisée dans un segment de transition par une décroissance longitudinale progressive de la largeur de ce segment amont avec croissance longitudinale progressive de la largeur de ce segment aval.

7. Amplificateur selon la revendication 1, caractérisé par le fait que la courbe spectrale de gain du deuxième segment d'amplification présente un décalage spectral par rapport à la courbe spectrale du gain du premier segment d'amplification.

8. Amplificateur selon la revendication 7, ledit décalage spectral, étant compris entre 5 nm et 50 nm.

9. Amplificateur selon la revendication 1, cet amplificateur constituant un dispositif de transcription de signal optique pour recevoir une première et une deuxième ondes lumineuses, au moins cette première onde étant modulée en amplitude par un signal, et pour transcrire ce signal sur cette deuxième onde, cet amplificateur étant tel que la modulation d'amplitude de la première onde provoque une modulation de la densité de porteurs de charges dans cet amplificateur pour que cette modulation de densité entraîne une modulation correspondante du gain présenté par cet amplificateur pour cette deuxième onde lumineuse et applique ainsi à cette deuxième onde une modulation d'amplitude complémentaire de celle de la première onde.

10. Amplificateur selon la revendication 9, cet amplificateur constituant un convertisseur de longueur d'onde.
